# EUROPEAN PATENT APPLICATION

(11) **EP 4 528 762 A1**
(43) Date of publication of application: **26.03.2025**
(21) Application number: 23199358.5
(22) Date of filing: 25.09.2023
(51) Int. Cl.: H01G 9/20

(54) **POLYMER-IODINE BASED GEL AND SOLID THIN FILMS FOR ANTISEPTIC AND SUSTAINABLE OPTO-ELECTRONIC COMPONENTS**

(71) Applicant: Ecopolix AS, 7048 Trondheim Trondelag (NO)
(72) Inventor: BALCI, MUSTAFA HASAN, 08014 BARCELONA (ES)

(57) **Abstract**

Manufacturing muti-functional gel and dry thin films as diode, photodiode, and photo-sensor devices based on a redox couple generated from a polymer-iodine complex and mixture of an iodide salt as semiconductor hybrid materials. Stable, antiseptic, non-toxic, and sustainable opto-electronic components have been invented. The diode device (Fig.1) includes a bottom electrode (1), electron transport layer (2), active polymer-iodine complex layer (3) and or top electrode (4), whereas a photodiode device (Fig. 2) based on photo electrochemical design (Fig. 2) includes a bottom electrode (5), active polymer-iodine complex layer (6), electron transfer layer (7) and a photo-transparent top electrode (8).

## Description

### Technical field to which invention relates

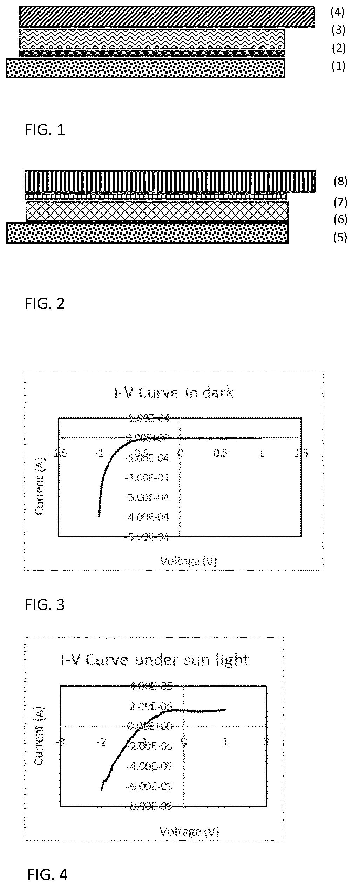

The present invention relates to a diode and photo-diode device (Fig 3. and 4), manufactured in gel and or solid thin film form based on polymer iodine and iodide salt mixed semiconductor hybrid material.

### Indication of background art

Mainly polymeric-ionic mixtures are demonstrated as electrolytes for dye sensitized solar cells. First time, we have demonstrated diode and photo-diode behavior of polymeric-ionic mixture directly on electrodes as a new hybrid semiconductor material.

### Technical problem to be solved

Conventional diodes include single crystalline semiconductors such as silicon which are not easy to recycle and have a high carbon footprint. Polymer ionic hybrid compounds have high ionic conductivity and thus, high photoelectric conversion efficiency with easy recyclability and less carbon footprint.

### Disclosure of invention

In accordance with the present invention, there is provided flexible or solid diode and photodiode device made of a new type of semiconductor thin film in gel or solid form based on polymer-iodide and iodide salt mixture. The special photodiode is photoelectrochemical device using photosensitive polymeric-ionic network that absorb the light to generate electron-hole pairs and an oxide semiconductor electrode formed of titanium or zinc or tin oxide on photo-transparent fluorine doped tin oxide or tin doped indium oxide coated glass for delivering generated electrons. An opposite electrode includes a platinum, graphite layer on top of conducting layer, or aluminum, silver, gold top electrode for diode only devices.

From among the components of the diode and photodiode, the polymeric-ionic mixture semiconductor hybrid material between the electrodes is the key in determining the photoelectric efficiency and durability of the device.

### Brief description of drawing

Fig. 1 Diode device includes bottom electrode, electron transfer layer, polymeric-ionic active layer, and top electrode.
Fig. 2 Photodiode device includes bottom electrode, polymeric-ionic active layer, electron transfer layer, and top electrode.
Fig. 3 Initial operating diode device demonstration.
Fig.4 Initial operating photo-diode device demonstration.

### Description of at least one way of carrying out the invention

According to the first aspect of the present invention, there is provided a gel or solid semiconductor thin film including a redox couple generated from a polymer-iodine complex and an iodide salt. According to a second aspect of the present invention there is provided a diode and photodiode including a top electrode; an electron transfer layer formed on the surface of the top electrode (7); and this top electrode (8) facing the bottom electrode (5) on which the light is penetrated through; and active layer a gel or solid polymer iodine-based iodide salt mixed hybrid material (6) according to the invention in its first aspect interposed between top and the bottom electrode. Further embodiments of the invention are as set out below or as defined in the sub-claims and figures.
1. In an embodiment, the polymer-iodine complex is represented by Formula1 below: 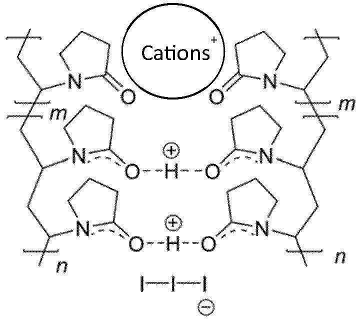
   wherein n is a number from 5 to 3,000, and
   m is a number from 5 to 30,000.
2. A gel or solid thin film semiconductor based on polyvinylpyrrolidone iodine mixed with iodide salts according to the invention may have high ionic conductivity and high stability and antiseptic properties as a new hybrid semiconductor material.
3. A gel or solid thin film of polymer-ionic mixture according to an aspect of the present invention includes a redox couple generated from a polymer-iodine complex and an iodide salt.
4. The polymer included in the polymer-iodine complex may be any one of various suitable polymers that enable formation of a complex with iodine. Examples of such suitable polymers are polyvinylalcohol, polyvinylpyrrolidone, polyvinylpyridine, nylon, polysaccharide, or mixtures thereof.
5. The quantity of the polymer-iodine complex can range from 10 to 200 parts by weight, relative to 20 parts by weight of the iodide salt. When the polymer-iodine complex is within this specified range, the polymer-iodine complex exhibits superior performance.
6. In the polymer-iodine complex, the mixed mole ratio of the polymer's repeating unit to iodine can vary from 50:1 to 1:1. If this ratio is maintained within the given range, the redox process is optimum.
7. The concentration of iodine in the polymer-iodine complex can be anywhere between 0.01 and 1 mol/L, or more specifically, between 0.03 and 0.5 mol/L. When the iodine concentration falls within this range, the recombination of electrons occurs optimized.
8. The iodide salt may include at least one selected from the group consisting of antimony iodide, lithium iodide, sodium iodide, potassium iodine, magnesium iodide, copper iodide, silicon iodide, manganese iodide, barium iodide, molybdenum iodide, calcium iodide, iron iodide, cesium iodide, zinc iodide, tin iodide.
9. The redox couple generated from a polymer-iodine complex may include a cation of the polymer-iodine complex and an iodine ion (I⁻/I₃ ⁻) from 5% to 25% as weight.
10. The gel or solid polymer-iodine mixture includes stabilizers such as citric acid, glycerin, mixed within purified water, and ethanol/ propanol.

## Claims

1. A gel or solid semiconductor thin film for a diode or photodiode, the polymer-ionic based thin film comprising: a redox couple generated from a polymer-iodine complex and an iodide salt.

2. The gel or solid thin film of claim 1, wherein the polymer of the polymer-iodine complex comprises at least one selected from the group consisting of polyvinylalcohol, polyvinylpyrrolidone, polyvinylpyridine, polyethyleneglycol, and polysaccharide.

3. The gel or solid thin film of claim 1, wherein the polymer-iodine complex is represented by polyvinylpyridine iodine with formula 1 below: 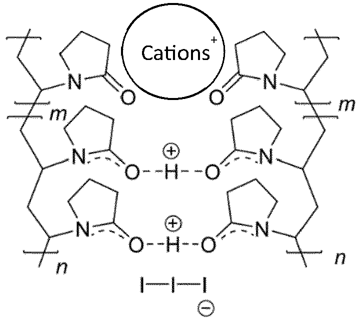
wherein n is a number from 5 to 3,000, and
m is a number from 5 to 30,000.

4. The gel or solid polymer-iodide thin film of claim 1, wherein in the polymer-iodine complex, a mixed mole ratio of a repeating unit of the polymer to the iodine is in a range of 50:1 to 1:1.

5. The gel or solid polymer-iodide thin film of claim 1, wherein the redox couple generated from the polymer-iodine complex and the iodide salt comprises a cation of the polymer-iodine complex and an iodine ion (I⁻/I₃ ⁻).

6. The gel electrolyte of claim 1, wherein the redox couple is in the polymer-iodine complex can range from 10 to 200 parts by weight, relative to 20 parts by weight of the iodide salt.

7. The redox couple generated from a polymer-iodine complex may include a cation of the polymer-iodine complex and an iodine ion (I⁻/I₃ ⁻) from 5% to 25% as weight.

8. The gel or solid film made of polymer-ionic mixture of claim 1, wherein the diode and photodiode devices have an average gel/solid thin film thickness of between 100 or 2500 nm.

9. The gel or solid film made of polymer-ionic mixture of claim 1, wherein the iodide salt comprises at least one selected from the group consisting of antimony iodide, lithium iodide, sodium iodide, potassium iodine, magnesium iodide, copper iodide, silicon iodide, manganese iodide, barium iodide, molybdenum iodide, calcium iodide, iron iodide, cesium iodide, zinc iodide, tin iodide.

10. A diode device comprising:
a bottom electrode (1).
an electron transfer layer on surface of the bottom electrode (2).
a top electrode facing the bottom electrode (4); and
a gel or solid thin film polymer-iodide complex (3) interposed between bottom electrode and
the top electrode, the gel or solid thin film polymer-iodide complex comprising:
a redox couple generated from a polymer-iodine complex and an iodide salt mixture as in claim1.

11. A photodiode device comprising:
a bottom electrode (5);
a top electrode facing the bottom electrode (8); and electron transfer layer on the surface of the top electrode (7).
a gel or solid thin film polymer-iodide complex (6), which is the light absorption layer,
interposed between bottom electrode and the top electrode, the gel or solid thin film polymer-iodide complex comprising:
a redox couple generated from a polymer-iodine complex and an iodide salt mixture as in claim 1.

12. Bottom electrode for diode (1) and photo transparent top electrode for photodiode (8) and on top of it an oxide semiconductor electrode formed of titanium or zinc or tin oxide (2, 7) on fluorine or tin doped inidum oxide coated glass (1, 8) for delivering generated electrons. An opposite electrode including a platinum, graphite layer (5) for photodiode only devices, or aluminum, silver, gold top electrode (4) for diode only devices.
